# EUROPÄISCHE PATENTSCHRIFT

(11) **EP 2 091 081 B1**
(45) Veröffentlichungstag und Bekanntmachung des Hinweises auf die Patenterteilung: **28.07.2010**
(21) Anmeldenummer: 08021975.1
(22) Anmeldetag: 18.12.2008
(51) Int. Cl.: H01L 23/373

(54) **Schaltungsanordnung mit Bondverbindung**
Switching assembly with bond connection
Agencement de commutation doté d'une liaison par soudage

(30) Priorität: 13.02.2008 DE 102008008853
(43) Veröffentlichungstag der Anmeldung: 19.08.2009
(73) Patentinhaber: SEMIKRON Elektronik GmbH & Co. KG, 90431 Nürnberg (DE)
(72) Erfinder: Lederer, Marco, 90453 Nürnberg (DE); Walenta, Nicole, 90530 Wendelstein (DE)

(56) Entgegenhaltungen:
- DE-C1- 10 237 561
- DE-U1- 29 823 619
- US-A1- 2007 141 755

## Beschreibung

Die Erfindung beschreibt eine Schaltungsanordnung mit einem Substrat, hierauf angeordneten Leiterbahnen, und auf mindestens einer dieser Leiterbahnen angeordnet mindestens einem Leistungshalbleiterbauelement. Das jeweilige Leistungshalbleiterbauelement ist mit einer ersten Leiterbahn mittels einer grundsätzlich seit langem bekannten Bondverbindung elektrisch leitend verbunden. Derartige Schaltungsanordnungen finden bevorzugt Anwendung in Leistungshalbleitermodulen.

Bekannt sind verschiedenen Substratvarianten, vorzugsweise mit einem isolierenden Grundkörper wie beispielhaft als AMB- (active metal braze), DCB- (direct copper bonding) oder IMS- (insulated metal substrat) Substrate. Auf zweiten Leiterbahnen dieser Substrate sind die Leistungshalbleiterbauelemente vorzugsweise stoffschlüssig und elektrisch leitend angeordnet.

Weiteren elektrischen Kontakt des Leistungshalbleiterbauelements mit weiteren Leiterbahnen, beispielhaft der ersten Leiterbahn, sind häufig mittels Bondverbindungen realisiert, die für Lastanschlüsse eine Mehrzahl einzelner Bonddrähte aufweisen.

Bedingt durch die Weiterentwicklung von Leistungshalbleiterbauelementen verringert sich deren laterale Ausdehnung und somit deren Fläche bei gleich bleibender Stromtragfähigkeit. Bekannt sind beispielhaft Leistungshalbleiterbauelement mit zwei Lastanschlussflächen gleicher Polarität, beispielhaft Emitteranschlussflächen von Leistungstransistoren. Hierbei ist es für die Belastung des Leistungshalbleiterbauelements bevorzugt, wenn beide Emitteranschlussflächen homogen mit Strom beaufschlagt werden.

Die Stromtragfähigkeit der elektrischen Verbindung mittels einer Bondverbindung wird bestimmt durch den Durchmesser des einzelnen Bonddrahts und der Anzahl der Bonddrähte. Somit kann es notwendig und sinnvoll sein eine ungerade Anzahl von Bonddrähten in einer Bondverbindung von einer Leiterbahn des Substrats zu den Lastanschlussflächen des Leistungstransistors vorzusehen.

In einer Vielzahl von Anwendungen sind zusätzlich Lastanschlussflächen von Leistungsdioden mittels der gleichen Bondverbindung mit den Lastanschlussflächen der Leistungstransistoren verbunden. Hierbei kann die Größe der Lastanschlussfläche der Leistungsdiode die Anzahl der Bonddrähte pro Bondverbindung begrenzen.

[6a] Die Druckschrift DE 10237561 offenbart einen Schaltungsaufbau für Leistungshalbleitermodule, die Leistungshalbleiterbauelemente und Verbindungsbahnen auf einem isolierten Substrat aufweist. Weiter weist die Offenbarung eng benachbart angeordnete Gleichstromanschlussleiter, die parallel und eng benachbart zur Substratoberfläche angeordnet sind, und einen Wechselstromanschlussleiter der ebenfalls parallel zur Substratoberfläche verläuft.

Der Erfindung liegt die Aufgabe zugrunde eine Schaltungsanordnung anzugeben, die eine homogene Strombeaufschlagung von zwei Lastanschlussflächen gleicher Polarität eines Leistungshalbleiterbauelements bei einer ungeraden Anzahl von Bonddrähten in einer Bondverbindung ermöglicht.

Diese Aufgabe wird erfindungsgemäß gelöst, durch eine Schaltungsanordnung mit den Merkmale des Anspruchs 1. Bevorzugte Ausführungsformen sind in den Unteransprüchen beschrieben.

Ausgangspunkt der erfindungsgemäßen Schaltungsanordnung ist ein Substrat vorzugsweise der oben genannten Art. Dieses weist eine Mehrzahl von Leiterbahnen auf, wobei auf einer zweiten dieser Leiterbahnen mindestens ein erstes Leistungshalbleiterbauelement angeordnet ist. Dieses mindestens eine Leistungshalbleiterbauelement ist mittels einer zugeordneten Bondverbindung mit einer ersten Leiterbahn elektrisch leitend verbunden.

Das jeweilige erste Leistungshalbleiterbauelement weist eine erste und eine zweite Lastanschlussfläche gleicher Polarität auf. Die Bondverbindung der Schaltungsanordnung weist eine ungerade Anzahl N von Bonddrähten auf, wobei die erste Hälfte der N-1 Bonddrähte von einer ersten Leiterbahn des Substrats zur ersten Lastanschlussfläche reichen. Die zweite Hälfte der N-1 Bonddrähte reicht von dieser ersten Leiterbahn zur zweiten Lastanschlussfläche. Erfindungsgemäß weist der N-te von der ersten Leiterbahn ausgehende Bonddraht sowohl auf der ersten als auch auf der zweiten Lastanschlussfläche mindestens einen Bondfuß auf und ist somit mit beiden Lastanschlussflächen elektrisch leitend verbunden.

Durch diese Ausgestaltung wird eine homogen Strombeaufschlagung beider Lastanschlussflächen und damit des gesamten Leistungshalbleiterbauelements erzielt. Dies ist notwendig, um die volle Leistungsfähigkeit des Leistungshalbleiterbauelements, auch im Betrieb an dessen Leistungsgrenze zu erhalten.

Besonders bevorzugte Weiterbildungen dieser Schaltungsanordnung sind in der jeweiligen Beschreibung der Ausführungsbeispiele genannt. Die erfinderische Lösung wird zudem an Hand der Ausführungsbeispiele der Fig. 1 bis 3 weiter erläutert.

Fig. 1 zeigt eine erste erfindungsgemäße Schaltungsanordnung.

Fig. 2 zeigt die Anordnung der Bonddrähte einer Bondverbindung eines Leistungshalbleiterbauelements einer erfindungsgemäßen Schaltungsanordnung.

Fig. 3 zeigt eine zweite erfindungsgemäße Schaltungsanordnung.

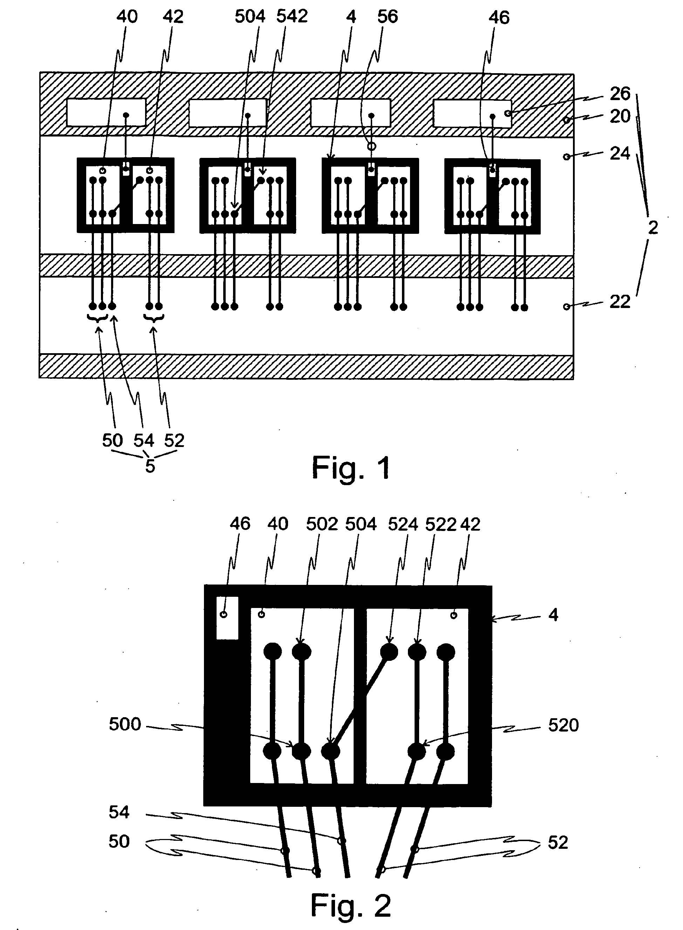

Fig. 1 zeigt eine erste erfindungsgemäße Schaltungsanordnung ausgebildet als Parallelschaltung einer Mehrzahl von Leistungsschaltern, wie sie beispielhaft Teil eines Leistungshalbleitermoduls ist. Die Schaltungsanordnung besteht hier aus einem der oben genannten Substrate (2), beispielhaft einem DCB- Substrat mit einem keramischen Isolierstoffkörper (20) und hierauf angeordneten metallischen Leiterbahnen (22, 24, 26). Eine erste Leiterbahn (22) führt hierbei beispielhaft Wechselspannungspotential, eine zweite (24) Gleichspannungpotential positiver Polarität und dritte Leiterbahnen (26) führen Steuerpotential.

Auf der zweiten Leiterbahn (24) und mit dieser elektrisch leitend verbunden sind parallel geschaltete erste Leistungshalbleiterbauelemente (4), hier Feldeffekt-Leistungstransistoren angeordnet. Diese Leistungstransistoren (4) weisen auf ihrer dem Substrat (2) abgewandten Seite zwei Lastanschlussflächen (40, 42) gleicher Polarität, sowie eine Steueranschlussfläche (46) auf. Die jeweilige Steueranschlussfläche (46) ist mit einer zugeordneten dritten Leiterbahn (26) des Substrats (2) mittels einer Drahtbondverbindung (56) elektrisch leitend verbunden.

Die elektrisch leitende Verbindung zwischen der ersten Leiterbahn (22) des Substrats (2) und den Lastanschlussflächen (40, 42) des jeweiligen Leistungstransistors (4) ist ebenfalls mittels jeweils einer Bondverbindung (5) ausgebildet. Die Bondverbindung (5) weist hierbei, da dies für die Stromtragfähigkeit der Verbindung ausreichend ist, eine ungerade Anzahl von fünf Bonddrähten (50, 52, 54) auf. Die erste Hälfte (52) von vier dieser fünf Bonddrähte reicht zur ersten Lastanschlussfläche (40) des Leistungstransistors (4) und weist auf dieser zwei Bondfüße (500, 502) je Bonddraht auf. Die zweite Hälfte (52) von vier dieser fünf Bonddrähte reicht zur zweiten Lastanschlussfläche (42) des Leistungstransistors (4) und weist auf dieser ebenfalls zwei Bondfüße (520, 522) je Bonddraht auf.

Erfindungsgemäß reicht der fünft Bonddraht (54) von der ersten Leiterbahn (22) zur ersten Lastanschlussfläche (40) des Leistungstransistors (4) und weist auf dieser einen Bondfuß (504) auf. Weiterhin reicht dieser fünfte Bonddraht (54) zur zweiten Lastanschlussfläche (42) und weist mit dieser ebenfalls einen Bondfuß (524) auf. Somit weist die Bondverbindung (5) zwischen der ersten Leiterbahn (22) des Substrats (2) mit dem Leistungstransistor (4) fünf Bonddrähte (50, 52, 54) und jeweils fünf Bondfüßen pro Lastanschlussfläche (40, 42) auf. Hierdurch kann die Strombeaufschlagung des Leistungstransistor (4) homogen verteilt auf seine beiden Lastanschlussflächen (40, 42) gleicher Polarität erfolgen.

Fig. 2 zeigt die Anordnung der Bonddrähte (50, 52, 54) einer Bondverbindung (5) eines Leistungshalbleiterbauelements (4), hier eines IGBT- Leitungstransistor, einer erfindungsgemäßen Schaltungsanordnung. Dargestellt ist ein Leistungstransistor (4) mit zwei Lastanschlussflächen (40, 42) gleicher Polarität, hier dem Emitteranschluss, sowie einer Steueranschlussfläche (46), dem Gateanschluss. Die beiden Lastanschlussflächen (40, 42) weisen hier, wie bevorzugt, gleichen Flächeninhalt auf.

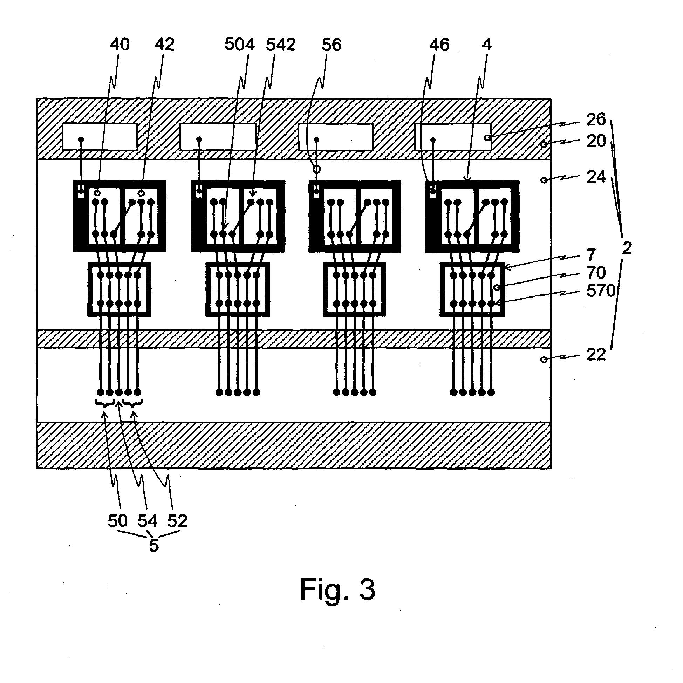

Die nur teilweise dargestellte Bondverbindung (5, vgl. Fig. 3) dieses Leistungstransistors (4) weist eine ungerade Anzahl, hier fünf, Bonddrähte (50, 52, 54) auf. Die ersten beiden Bonddrähte (50) sind der ersten Lastanschlussfläche (40) zugeordnet und weisen jeweils zwei Bondfüße (500, 502) auf dieser Lastanschlussfläche (40) auf. Die zweiten beiden Bonddrähte (52) sind der zweiten Lastanschlussfläche (42) zugeordnet und weisen ebenfalls jeweils zwei Bondfüße (520, 522) auf dieser Lastanschlussfläche (42) auf.

Erfindungsgemäß weist der fünfte Bonddraht (54) der Bondverbindung (5) einen Bondfuß (504) mit der ersten Lastanschlussfläche (40) und einen Bondfuß (524) mit der zweiten Lastanschlussfläche (42) auf. Somit ist bei insgesamt fünf Bonddrähte (50, 52, 54) mit zusammen zehn Bondfüßen (500, 502, 504, 520, 522, 524) auf beiden Lastanschlussflächen (40, 42) sichergestellt, dass die Strombeaufschlagung je Lastanschlussfläche (40, 42) homogen ist. Somit kann der Leistungstransistor (4) im Betrieb gleichmäßig mit Strom belastet werden.

Fig. 3 zeigt eine zweite erfindungsgemäße Schaltungsanordnung, ebenfalls eine Parallelschaltung einer Mehrzahl von Leistungsschaltern, hier bestehend aus einem Leistungstransistor (4) und einer antiparallel geschalteten Leistungsdiode (7). Hierbei wird deutlich, wie ein zweites Leistungshalbleiterbauelement die Anzahl der Bonddrähte einer Bondverbindung begrenzen kann. Auf der zweiten Leiterbahn (24) des Substrats (2) sind hier je ein IGBT- Leistungstransistor (4), vgl. Fig. 2, und je eine diesem zugeordnete Leistungsdiode (7) dargestellt. Die Lastanschlussflächen (40, 42, 70) der einander zugeordneten Leistungshalbleiterbauelemente (4, 7) sind mittels einer Bondverbindung (5) miteinander und mit der ersten Leiterbahn (22) des Substrats (2) elektrisch leitend verbunden.

Aus ökonomischen Gründen werden hierbei Leistungshalbleiterbauelemente (4, 7) ausgewählt, deren Fläche minimal ist bei notwendiger Stromtragfähigkeit. Im dargestellten Beispiel ist es aus technologischen Gründen der Herstellung der Bondverbindung nur möglich auf der Lastanschlussfläche (70) der Diode (7) maximal fünf Bonddrähte (50, 52, 54) nebeneinander anzuordnen. In Richtung des Verlaufs des jeweiligen Bonddrahts (50, 52, 54) weist dieser zwei Bondfüße (570) mit der Diode (7) auf. Eine geringere Anzahl von Bonddrähten (50, 52, 54) pro Bondverbindung (5) ist ebenfalls nicht möglich, da diese die Stromtragfähigkeit der Bondverbindung (5) um ein Fünftel reduzieren würde und somit die Leistung der Leistungshalbleiterbauelemente (4, 7) und damit der Schaltungsanordnung nicht ausgeschöpft werden könnte.

Durch diese Begrenzung der jeweiligen Bondverbindung (5) auf fünf Bonddrähte (50, 52, 54) ist es im weiteren Verlauf der Bondverbindung (5) notwendige den IGBT-Leistungstransistor (4) homogen mit Strom zu beaufschlagen, was durch die erfindungsgemäße Ausbildung der Anordnung des fünften Bonddrahtes (54) erfolgt. Dieser weist sowohl mit der ersten (40) als auch mit der zweiten (42) Lastanschlussfläche des tGBT- Leistungstransistors (4) je einen Bondfuß (504, 524) auf. Die verbleibenden vier Bonddrähte (50, 52) weisen bekanntermaßen mit den ihnen zugeordneten Lastanschlussfläche (40, 42) gleicher Polarität je zwei Bondfüße (500, 502, 520, 522) auf.

## Patentansprüche

1. Schaltungsanordnung mit einem Leiterbahnen (22, 24, 26) aufweisenden Substrat (2), mindestens einem ersten Leistungshalbleiterbauelement (4) und einer zugeordneten Bondverbindung (5), wobei das erste Leistungshalbleiterbauelement (4) eine erste (40) und eine zweite (42) Lastanschlussfläche gleicher Polarität aufweist, **dadurch gekennzeichnet, dass** die Bondverbindung (5) eine ungerade Anzahl N von Bonddrähten (50, 52, 54) aufweist, die erste Hälfte (50) der N-1 Bonddrähte von einer ersten Leiterbahn (22) des Substrats (2) zur ersten Lastanschlussfläche (40) reicht, die zweite Hälfte (52) der N-1 Bonddrähte von dieser ersten Leiterbahn (22) zur zweiten Lastanschlussfläche (42) reicht und der N-te (54), von der ersten Leiterbahn (22) ausgehende, Bonddraht sowohl auf der ersten (40) als auch auf der zweiten (42) Lastanschlussfläche mindestens einen Bondfuß (504, 524) aufweist.

2. Schaltungsanordnung nach Anspruch 1,
wobei das erste Leistungshalbleiterbauelement (4) ein Leistungstransistor ist.

3. Schaltungsanordnung nach Anspruch 1,
wobei das Substrat (2) ein Isoliersubstrat mit einer Mehrzahl auf einer Oberfläche angeordneten Leiterbahnen (22, 24, 26) ist und das mindestens eine Leistungshalbleiterbauelement (4) stoffschlüssig und elektrisch leitend mit einer zweiten Leiterbahn (24) verbunden ist.

4. Schaltungsanordnung nach Anspruch 1,
wobei die Bondverbindung (5) die erste Leiterbahn (22) jeweils mit dem ersten (4) und einem zweiten (7) Leistungshalbleiterbauelement verbindet.

5. Schaltungsanordnung nach Anspruch 4,
wobei das zweite Leistungshalbleiterbauelement (7) eine Leistungsdiode ist.

## Claims

1. A circuit arrangement with a substrate (2) having conducting tracks (22, 24, 26), at least one first power semiconductor component (4) and an assigned bonding connection (5), wherein
the first power semiconductor component (4) has a first (40) and a second (42) load connection pad of the same polarity,
**characterised in that** the bonding connection (5) has an odd number N of bonding wires (50, 52, 54), the first half (50) of the N-1 bonding wires extend across from a first conducting track (22) of the substrate (2) to the first load connection pad (40), the second half (52) of the N-1 bonding wires extend across from this first conducting track (22) to the second load connection pad (42), and the Nth bonding wire (54), starting from the first conducting track (22) has at least one bonding foot (504, 524) on both the first (40) and also the second (42) load connection pad.

2. The circuit arrangement according to Claim 1, wherein
the first power semiconductor component (4) is a power transistor.

3. The circuit arrangement according to Claim 1, wherein
the substrate (2) is an insulating substrate with a multiplicity of conducting tracks (22, 24, 26) arranged on one surface, and the at least one power semiconductor component (4) is connected by means of a material bond with a second conducting track (24) in an electrically conducting manner.

4. The circuit arrangement according to Claim 1, wherein
the bonding connection (5) connects the first conducting track (22) in each case with the first (4) and a second (7) power semiconductor component.

5. The circuit arrangement according to Claim 4, wherein
the second power semiconductor component (7) is a power diode.

## Revendications

1. Agencement de circuit doté d'un substrat (2) présentant des pistes conductrices (22, 24, 26), d'au moins un premier composant à semi-conducteurs de puissance (4) et d'une liaison par bonding (5) attribuée, le premier composant à semi-conducteurs (4) présentant une première surface de raccordement de charge (40) et une seconde surface de raccordement (42) de même polarité, **caractérisé en ce que** la liaison par bonding (5) présente un nombre N impair de fils de bonding (50, 52, 54), la première moitié (50) des N-1 fils de bonding allant d'une première piste conductrice (22) du substrat (2) à la première surface de raccordement de charge (40), la seconde moitié (52) des N-1 fils de bonding allant de cette première piste conductrice (22) à la seconde surface de raccordement de charge (42) et le N-ième fil de bonding (54) partant de la première piste conductrice (22) présentant au moins une base de bonding (504, 524) aussi bien sur la première surface de raccordement de charge (40) que sur la seconde surface de raccordement de charge (42).

2. Agencement de circuit selon la revendication 1, le premier composant à semi-conducteurs (4) étant un transistor de puissance.

3. Agencement de circuit selon la revendication 1, le substrat (2) étant un substrat isolant avec une pluralité de pistes conductrices (22, 24, 26) disposées sur une surface et le au moins un composant à semi-conducteurs de puissance (4) étant relié par adhésion de matière et de façon électro-conductrice à une seconde piste conductrice (24).

4. Agencement de circuit selon la revendication 1, la liaison par bonding (5) reliant la première piste conductrice (22) respectivement au premier composant à semi-conducteurs de puissance (4) et à un second composant à semi-conducteurs de puissance (7).

5. Agencement de circuit selon la revendication 4, le second composant à semi-conducteurs de puissance (7) étant une diode de puissance.
